# EUROPÄISCHE PATENTANMELDUNG

(11) **EP 2 682 770 A2**
(43) Veröffentlichungstag der Anmeldung: **08.01.2014**
(21) Anmeldenummer: 13164753.9
(22) Anmeldetag: 22.04.2013
(51) Int. Cl.: G01R 33/00

(54) **Magnetfeldsensor**

(30) Priorität: 06.07.2012 DE 102012211843
(71) Anmelder: ROBERT BOSCH GMBH, 70442 Stuttgart (DE)
(72) Erfinder: Grosser, Michaela, 99817 Eisenach (DE)

(57) **Zusammenfassung**

Ein Magnetfeldsensor 20 umfasst mindestens eine integrierte Schaltung 26 mit mindestens einem Magnetfeldsensorelement, mindestens einem magnetischen Leiter 28 und ein Gehäuse 22, in dem die integrierte Schaltung 26 und der magnetische Leiter 28 aufgenommen sind. Der magnetische Leiter 28 ist dazu ausgeführt, ein Magnetfeld auf die integrierte Schaltung 26 zu lenken. Der magnetische Leiter 28 weist weichmagnetische Partikel 16 in einem Polymermaterial 12 auf.

## Beschreibung

### Gebiet der Erfindung

Die Erfindung betrifft einen Magnetfeldsensor.

### Hintergrund der Erfindung

Magnetfeldsensoren werden für viele Applikationen wie etwa für Drehzahlsensoren, Wegsensoren und Positionssensoren eingesetzt. In Magnetfeldsensoren können ASICS oder Sensorelemente eingesetzt werden welche auf Basis verschiedener physikalischer Effekte wie z.B. Halleffekt, AM R, GMR u.a. in der Lage sind ein Magnetfeld zu detektieren. Die Gruppe der Sensorelemente wird im Folgenden ebenfalls als ASIC bezeichnet. Die ASICs sind gewöhnlich eingehaust.

Zwischen der zu überwachenden Quelle des Magnetfeldes im Rahmen der Erläuterung als Magnet bezeichnet, unabhängig von Form und Felderzeugung und den ASICs des Magnetfeldsensors ist häufig ein zu überbrückender Spalt vorhanden, der die Stärke des Magnetfelds am Sensorelement vermindert. Zu diesem Luftspalt können Gehäusewandungen, insbesondere das Gehäuse des Magnetfeldsensors, und ein Luftspalt beitragen. Die Stärke des Magnetfeldes eines Permanentmagneten oder Elektromagneten nimmt in Abhängigkeit von Geometrie und Umwelt ca. quadratisch mit der Entfernung ab.

Die Empfindlichkeit des Magnetfeldsensors nimmt somit bei einem breiten Spalt stark ab.

Um das Magnetfeld zu konzentrieren, werden weichmagnetische Materialien in Form von beispielsweise weichmagnetischen Scheiben gegenüber der Quelle des Magnetfeldes hinter dem Sensor platziert. Dies sorgt für eine Konzentration des magnetischen Feldes und kann dazu dienen, breitere Spalte zu überbrücken, als ohne die Verwendung einer weichmagnetischen Scheibe möglich wäre.

### Zusammenfassung der Erfindung

Es ist Aufgabe der Erfindung, die Empfindlichkeit eines Magnetfeldsensors auf einfache Art und Weise zu erhöhen.

Diese Aufgabe wird durch den Gegenstand der unabhängigen Ansprüche gelöst. Weitere Ausführungsformen der Erfindung ergeben sich aus den abhängigen Ansprüchen und aus der folgenden Beschreibung.

Gemäß einer Ausführungsform der Erfindung umfasst ein Magnetfeldsensor wenigstens eine integrierte Schaltung mit wenigstens einem Magnetfeldsensorelement, wenigstens einen magnetischen Leiter und ein Gehäuse, in dem die integrierte Schaltung und der magnetische Leiter aufgenommen sind. Der magnetische Leiter ist dazu ausgeführt, ein Magnetfeld auf die integrierte Schaltung zu lenken. Weiter weist der magnetische Leiter weichmagnetische Partikel in einem Polymermaterial auf.

Der aus einem weichmagnetischen Material bestehende magnetische Leiter eines herkömmlichen Sensors kann also durch ein frei formbares Polymer ersetzt werden, in dem weichmagnetische Partikel aufgenommen sind. Die Verwendung eines solchen gefüllten Polymermaterials kann den Abfall des Magnetfeldes, der durch den Spalt zwischen zu vermessendem Magneten und Sensorelement erzeugt wird, verringern.

Ein weichmagnetisches Material ist dabei ein ferromagnetisches Material, das sich in einem Magnetfeld verhältnismäßig leicht magnetisieren und entmagnetisieren bzw. ummagnetisieren lässt. Beispiele für weichmagnetische Materialien sind Legierungen basierend auf Eisen, Kobalt und Nickel oder keramische Werkstoffe z.B. in Form von Ferriten.

Die Verwendung des gefüllten Polymermaterials gestattet es, frei formbare Magnetfeldverstärker bzw. magnetische Leiter zu bauen, da ein Polymer in der Regel leichter als ein weichmagnetisches Material geformt werden kann.

Die integrierte Schaltung kann beispielsweise ein ASIC (eine anwendungsspezifische integrierte Schaltung) sein. Das Magnetfeldsensorelement kann ein Hall-Sensorelement sein, welches in die integrierte Schaltung integriert ist.

Bei dem Gehäuse kann es sich um ein Package bzw. eine Kunststoffhülle der integrierten Schaltung handeln.

Ein derartiger Magnetfeldsensor kann beispielsweise als Drehzahlsensor oder Positionssensor sowie in anderen auf magnetischer Basis arbeitenden Sensorsystemen eingesetzt werden.

Gemäß einer Ausführungsform der Erfindung sind die weichmagnetischen Partikel in das Polymermaterial eingegossen. Ein weichmagnetisches Material wird beispielsweise in Form von Kugeln oder anders geformten Partikeln dem Polymer vor oder während des Spritzprozesses hinzugefügt und kann somit als Leiter für das Magnetfeld dienen. Als Polymer kann beispielsweise ein Duroplast verwendet werden.

Bei entsprechender Verteilung der weichmagnetischen Partikel im Polymer können sich für das gefüllte Polymer ähnliche Eigenschaften wie für einen geblätterten Kern in einem Transformator ergeben. Die Partikel sind elektrisch isoliert, leiten aber das Magnetfeld. Auf diese Weise können Wirbelströme verhindert werden.

In Abhängigkeit der Perkolation (d.h. der Verteilung der Partikel im Polymer), der Füllkorngröße der Partikel und dem weichmagnetischen Material der Partikel lassen sich somit elektrisch nichtleitende magnetische Leiter mit unterschiedlichen Eigenschaften herstellen.

Falls die weichmagnetischen Partikel eine ausreichend Restmagnetisierung aufweisen, ist auch eine Ausrichtung dieser Partikel im Magnetfeld machbar. Gemäß einer Ausführungsform der Erfindung ist das Gehäuse aus dem gleichen oder einem ähnlichen Polymermaterial wie der magnetische Leiter hergestellt. Auf diese Weise kann eine gute mechanische und auch stoffliche Anbindung des magnetischen Leiters an das Material des Gehäuses erfolgen. Gleichzeitig kann in Abhängigkeit der verwendeten Materialien eine hohe Flüssigkeitsdichtheit erreicht werden. Bei gleichen oder ähnlichen Polymermaterialen können unterschiedliche thermische Ausdehnungen reduziert werden, wodurch mechanische Spannungen auf den integrierten Schaltkreis vermindert werden können.

Das gefüllte Polymermaterial kann nun auf verschiedene Art und Weise geformt werden, um so die fokussierende und konzentrierende Eigenschaft des magnetischen Leiters umzusetzen.

Gemäß einer Ausführungsform der Erfindung umfasst der magnetische Leiter ein Leiterelement aus mit weichmagnetischen Partikeln gefülltem Polymermaterial. Das Leiterelement grenzt an eine Seite der integrierten Schaltung. Mit anderen Worten kann eine Seite des integrierten Schaltkreises mit dem gefüllten Polymermaterial bedeckt sein.

Gemäß einer Ausführungsform der Erfindung umfasst der magnetische Leiter Leiterelemente aus mit weichmagnetischen Partikeln gefülltem Polymermaterial, die an gegenüberliegende Seiten der integrierten Schaltung grenzen. Auch beide Seiten des integrierten Schaltkreises können von dem gefüllten Polymermaterial bedeckt sein.

Gemäß einer Ausführungsform der Erfindung ist wenigstens ein Leiterelement als Magnetfeldlinse ausgeführt. Dazu kann beispielsweise die dem integrierten Schaltkreis gegenüberliegende Fläche des scheibenförmigen Leiterelements konvex oder konkav geformt sein.

Gemäß einer Ausführungsform der Erfindung umfasst der magnetische Leiter ein Leiterelement aus mit weichmagnetischen Partikeln gefülltem Polymermaterial, das an eine Außenfläche des Gehäuses grenzt. Somit kann die effektive Breite eines Spalts zwischen Magnet und Sensorelement durch Ausnutzung des Gehäuses als magnetischer Leiter reduziert werden.

Mit dem gefüllten Polymermaterial ist es auch möglich, die Richtung eines Magnetfelds zu beeinflussen.

Gemäß einer Ausführungsform der Erfindung umfasst der magnetische Leiter ein strukturiertes Leiterelement aus mit weichmagnetischen Partikeln gefülltem Polymermaterial, das an eine Seite der integrierten Schaltung grenzt und das dazu ausgeführt ist, ein Magnetfeld in seiner Richtung umzulenken. Eine beliebige Form des magnetischen Leiters erlaubt den Einsatz geformter magnetischer Felder zur Verbesserung der Qualität der magnetischen Information.

Gemäß einer Ausführungsform der Erfindung umfasst das strukturierte Leiterelement einen abgeknickten länglichen Körper. Da das gefüllte Polymermaterial leicht geformt und in nahezu jede beliebige Form gegossen werden kann, kann es beispielsweise die Form eines Knies aufweisen.

Gemäß einer Ausführungsform der Erfindung umfasst der Magnetfeldsensor wenigstens zwei separate integrierte Schaltungen mit Magnetfeldsensorelement. D.h. der Magnetfeldsensor kann wenigstens zwei separate Chips enthalten, die jeweils wenigstens ein Sensorelement umfassen.

Mit dem gefüllten Polymermaterial kann das Magnetfeld nun auf die wenigstens zwei Chips fokussiert werden.

Gemäß einer Ausführungsform der Erfindung umfasst der magnetische Leiter ein Leiterelement aus mit weichmagnetischen Partikeln gefülltem Polymermaterial, das an beide integrierte Schaltungen grenzt. Der Magnetfeldsensor kann ein Leiterelement für eine beliebige Anzahl integrierter Schaltungen umfassen, das an diese integrierten Schaltungen angrenzt und eine magnetische Leitung zwischen diesen integrierten Schaltungen bereitstellen kann.

Gemäß einer Ausführungsform der Erfindung umfasst der magnetische Leiter für jede integrierte Schaltung ein Leiterelement aus mit weichmagnetischen Partikeln gefülltem Polymermaterial, das an die jeweilige integrierte Schaltung grenzt, und/oder umfasst der magnetische Leiter für jede integrierte Schaltung zwei Leiterelemente aus mit weichmagnetischen Partikeln gefülltem Polymermaterial, die jeweils an gegenüberliegende Seiten der zugehörigen integrierten Schaltung grenzen. Auch ist es möglich, dass die integrierten Schaltungen an einer oder an beiden Seiten von separaten Leiterelementen begrenzt sind.

Gemäß einer Ausführungsform der Erfindung grenzt der magentische Leiter bzw. das Leiterelement nicht unmittelbar an eine der Grenzflächen von beteiligten Komponenten an sondern weist einen Abstand zu diesen, insbesondere zu der integrierten Schaltung und/oder dem Sensorelement auf. Unabhängig von der Lagebeschreibung der Ausführungsform muss der magnetische Leiter nicht unbedingt an das Sensorelement angrenzen sondern kann auch einen definierten Abstand zu den Grenzflächen der beteiligten Komponenten aufweisen.

### Kurze Beschreibung der Figuren

Im Folgenden werden Ausführungsbeispiele der Erfindung mit Bezug auf die beiliegenden Figuren detailliert beschrieben.
Fig. 1 zeigt einen schematischen Querschnitt durch ein gefülltes Polymermaterial gemäß einer Ausführungsform der Erfindung.
Fig. 2 zeigt einen schematischen Querschnitt durch einen Magnetfeldsensor gemäß einer Ausführungsform der Erfindung.
Fig. 3 zeigt einen schematischen Querschnitt durch einen Magnetfeldsensor gemäß einer weiteren Ausführungsform der Erfindung.
Fig. 4 zeigt einen schematischen Querschnitt durch einen Magnetfeldsensor gemäß einer weiteren Ausführungsform der Erfindung.
Fig. 5 zeigt einen schematischen Querschnitt durch einen Magnetfeldsensor gemäß einer weiteren Ausführungsform der Erfindung. Fig. 6A zeigt einen schematischen Querschnitt durch einen Magnetfeldsensor mit zwei integrierten Schaltungen.
Fig. 6B zeigt ein Diagramm, das die Magnetfeldstärke bei dem Magnetfeldsensor aus der Fig. 6A darstellt.
Fig. 7A zeigt einen schematischen Querschnitt durch einen Magnetfeldsensor gemäß einer weiteren Ausführungsform der Erfindung.
Fig. 7B zeigt ein Diagramm, das die Magnetfeldstärke bei dem Magnetfeldsensor aus der Fig. 6B darstellt.
Fig. 8A zeigt einen schematischen Querschnitt durch einen Magnetfeldsensor gemäß einer weiteren Ausführungsform der Erfindung.
Fig. 8B zeigt ein Diagramm, das die Magnetfeldstärke bei dem Magnetfeldsensor aus der Fig. 8B darstellt.
Fig. 9A zeigt einen schematischen Querschnitt durch einen Magnetfeldsensor gemäß einer weiteren Ausführungsform der Erfindung.
Fig. 9B zeigt ein Diagramm, das die Magnetfeldstärke bei dem Magnetfeldsensor aus der Fig. 9B darstellt.

Grundsätzlich sind identische oder ähnliche Teile mit den gleichen Bezugszeichen versehen.

### Detaillierte Beschreibung von Ausführungsbeispielen

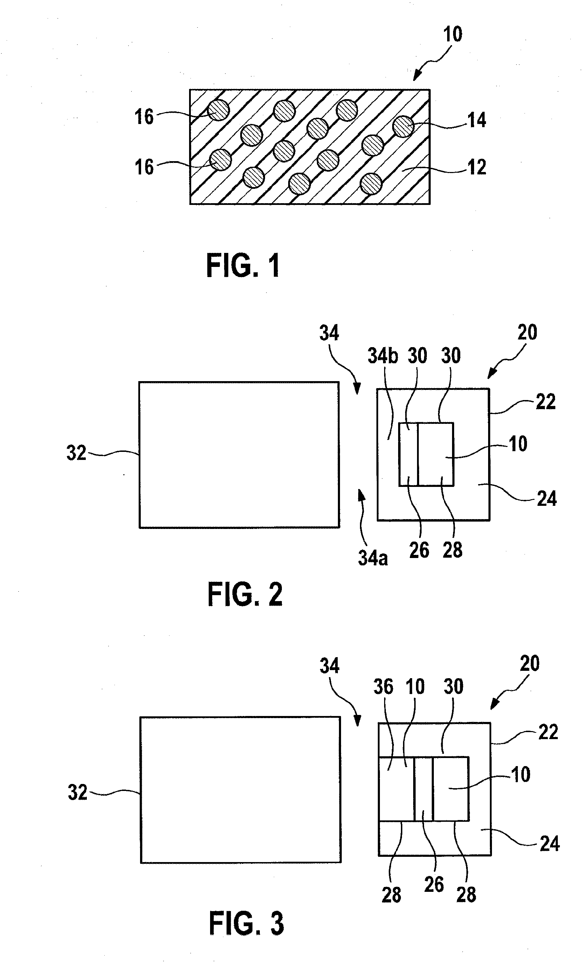

Fig. 1 zeigt ein gefülltes Polymermaterial 10, das ein (reines) Polymermaterial 12 und ein weichmagnetisches Material 14 umfasst. Das weichmagnetische Material 14 umfasst eine Mehrzahl von beispielsweise kugelförmigen Partikeln 16, von denen sich die meisten nicht berühren, so dass das gefüllte Polymermaterial 10 insgesamt im Wesentlichen ein elektrischer Nichtleiter ist, wenn das Polymer isolierend ist.

Das gefüllte Polymermaterial 10 kann z.B. durch Eingießen der Partikel 16 in das Polymermaterial 12, beispielsweise ein Duroplast, erzeugt werden. Die Materialeigenschaften des gefüllten Materials 10 können durch die Wahl des Polymers 12, des weichmagnetischen Materials 14, der Partikelgröße der Partikel 16 und deren durchschnittlichem Abstand im Polymermaterial 12 eingestellt werden.

Fig. 2 zeigt einen Magnetfeldsensor 20, der ein Package bzw. ein Gehäuse 22 aus einem weiteren Polymermaterial 24 umfasst. Das weitere Polymermaterial 24 kann das gleiche Polymermaterial 12 sein, das für das gefüllte Polymermaterial 10 verwendet wird.

Das Gehäuse 22 umschließt eine integrierte Schaltung 26 und einen magnetischen Leiter 28 aus gefülltem Polymermaterial 10. Die integrierte Schaltung 26 kann ein ASIC sein, der ein oder mehr -Sensorelemente enthält.

Der magnetische Leiter 28 weist ein Leiterelement 30 auf, das an eine Seite der integrierten Schaltung 26 grenzt, die einem Magneten 32 gegenüberliegt, der von dem Magnetfeldsensorelement 20 erfasst werden soll.

Zwischen dem Magnet 32 und den Sensorelementen auf der integrierten Schaltung 26 befindet sich ein Spalt 34, der einen Luftspalt 34a und den Teil 34b des Gehäuses 22 umfasst, der sich zwischen dem Luftspalt 34a und der integrierten Schaltung 26 befindet.

Das Leiterelement 30 aus gefülltem Polymermaterial 10 kann bündig mit der integrierten Schaltung 26 eingesetzt werden und beispielsweise vor einem weiterem Packaging, d.h. beispielsweise einem Eingießen in das weitere Polymermaterial 24, angespritzt werden. Dies kann die Positioniergenauigkeit erhöhen und somit eine höhere Stärke des Magnetfeldes als bei herkömmlichen Varianten erlauben.

Die Fig. 3 zeigt eine weitere Ausführungsform eines Magnetfeldsensors 20, bei dem der magnetische Leiter 28 weiter einen Magnetfeldleiter 36 bzw. Leiterelement 36 aus gefülltem Polymer 10 umfasst, der an die Seite der integrierten Schaltung 26 angrenzt, die auf den Magneten 32 zuweist. Zusätzlich grenzt der Magnetfeldleiter 36 direkt an die Außenfläche des Gehäuses 22 an.

Auf diese Weise wird der Spalt 34 durch die Verwendung eines Magnetfeldleiters 36 bzw. magnetischen Leiters 26 um die Dicke 34b des Gehäuses 22 reduziert. Dies kann die Empfindlichkeit des Magnetfeldsensors 20 erhöhen bzw. einen Sicherheitsgewinn darstellen.

Der Magnetfeldleiter 36 kann ein scheibenförmiges Leiterelement sein, das keine weitere Strukturierung aufweist.

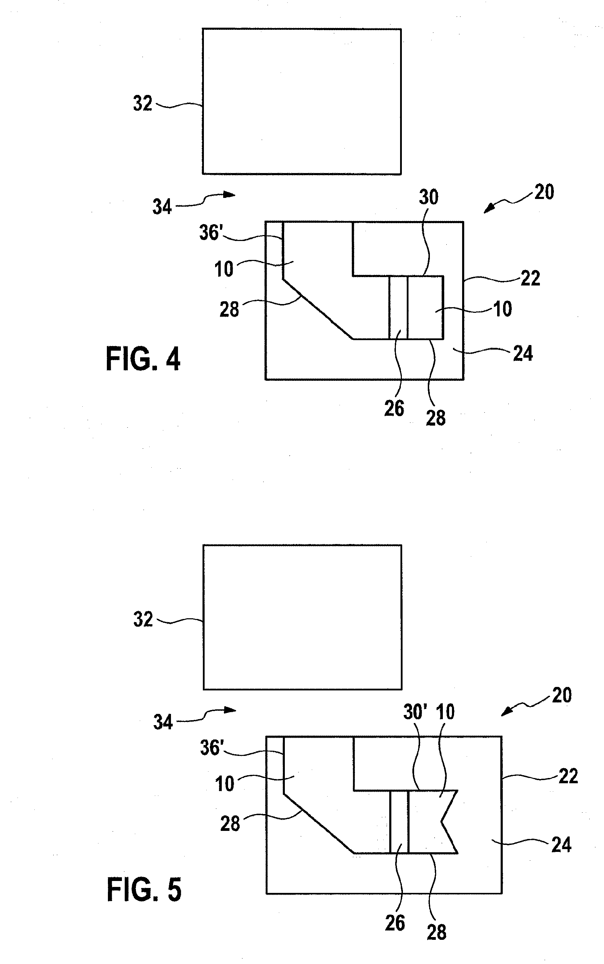

Im Gegensatz dazu zeigt die Fig. 4 einen Magnetfeldsensor 20 mit einem strukturierten Magnetfeldleiter 36'. Bei dem Magnetfeldsensor 20 der Fig. 4 ist die integrierte Schaltung 26 im Wesentlichen orthogonal zu einer Verbindungslinie zwischen dem Magneten 32 und dem Magnetfeldsensor 20 angeordnet. Der strukturierte Magnetfeldleiter 36' (der analog dem Magnetfeldleiter 36 an eine Außenfläche des Gehäuses 22 und an eine Seite der integrierten Schaltung 26 grenzt) ist abgewinkelt und ist dazu ausgeführt, ein Magnetfeld auf die integrierte Schaltung 26 zu lenken.

Beispielsweise kann auf diese Weise das Magnetfeld an schwer zugänglichen Stellen durch Verwendung eines gefüllten Polymers 20 zur integrierten Schaltung umgelenkt werden. Der Magnetfeldleiter 36' kann beliebig geformt sein.

Die Fig. 5 zeigt analog der Fig. 4 einen Magnetfeldsensor 20 mit einem strukturierten Magnetfeldleiter 36' und einem Leiterelement 30', das auf der gegenüberliegenden Seite an die integrierte Schaltung 26 grenzt. Im Gegensatz zu dem Leiterelement 30 ist das Leiterelement 30' strukturiert und als Magnetfeldlinse ausgeführt, indem beispielsweise das Leiterelement 30' eine konkave Form aufweist. Auch eine konvexe Form ist möglich.

Die Strukturierung des Leiterelements 30' erlaubt es, Randeffekte des Magnetfeldes auszugleichen. Durch die Verwendung eines leicht formbaren gefüllten Polymermaterials 10 kann die Strukturierung leicht und effizient umgesetzt werden.

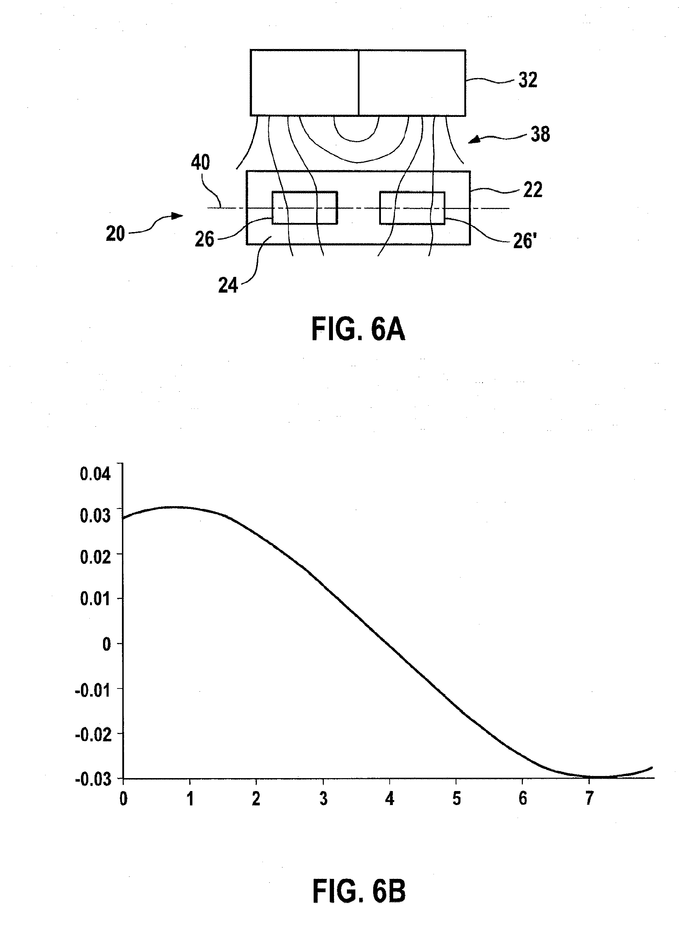

Die Fig. 6A zeigt einen Magnetfeldsensor 20, der zwei integrierte Schaltungen 26, 26' (beispielsweise ASICs) mit jeweils wenigstens einem Sensorelement umfasst. Mit dem Magnetfeldsensor 20 kann beispielsweise die Position eines Magneten 32 erfasst werden, der einen Polübergang in einer Richtung aufweist, in der auch die integrierten Schaltungen 26, 26' im Gehäuse 22 des Magnetfeldsensors 20 angeordnet sind.

Zum Vergleich mit den folgenden Ausführungsformen umfasst der in der Fig. 6A dargestellte Magnetfeldsensor 20 keinen magnetischen Leiter 28. In der Fig. 6A ist auch das Magnetfeld 38 des Magneten 32 dargestellt, das bereits durch die Komponenten der integrierten Schaltungen 26, 26' bereits etwas verformt werden kann.

Die Fig. 6B zeigt ein Diagramm, das die Stärke des Magnetfelds 38 in einer Ebene 40 darstellt, die durch die beiden integrierten Schaltungen 26, 26' verläuft.

In dem Diagramm sind nach rechts Längeneinheiten aufgetragen. Die integrierten Schaltungen 26, 26' befinden sich etwa bei 0,5 und 7,5. Nach oben ist der Wert der Normalkomponente 42 des Magnetfelds 38 in der Ebene 40 aufgetragen. Diese Werte sind in Tesla angegeben.

Wie aus der Fig. 6B hervorgeht, hat das Magnetfeld eine Stärke von etwa 0,03 Tesla in der Nähe der integrierten Schaltungen 26, 26'.

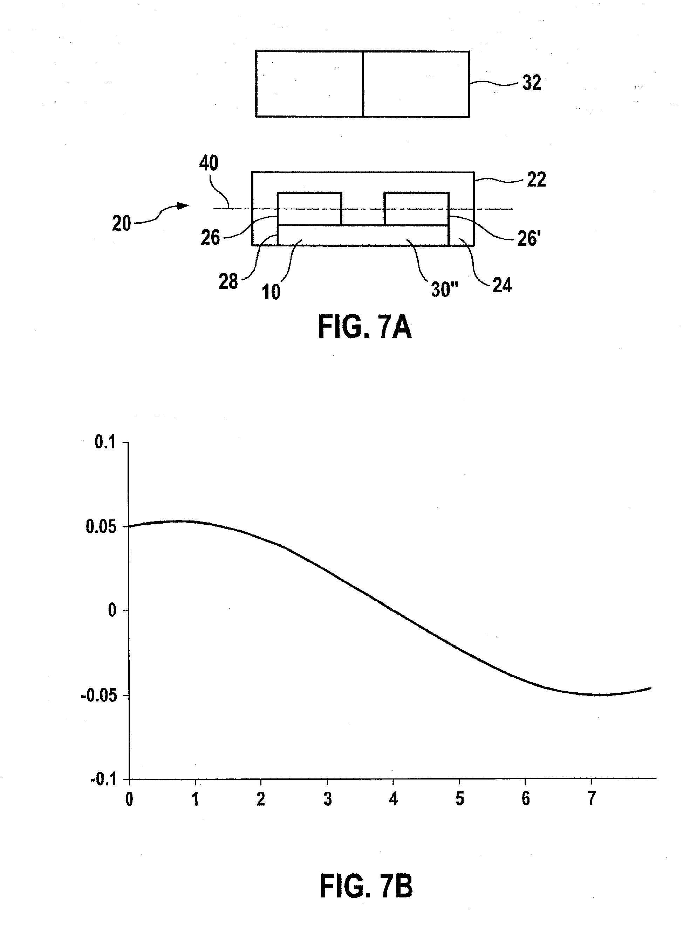

Die Fig. 7A zeigt einen Magnetfeldsensor 20 analog der Fig. 6A, der zusätzlich einen magnetischen Leiter 28 aus gefülltem Polymermaterial 10 in der Form eines Leiterelements 30" aufweist, das an beide integrierten Schaltungen 26, 26' grenzt. Das Leiterelements 30" ist dabei an den Seiten der integrierten Schaltungen 26, 26' angebracht, die von dem Magneten 32 weg weisen.

Die Fig. 7B zeigt ein Diagramm analog der Fig. 6B mit der Stärke des Magnetfelds 38 in der Ebene 40, das durch das Leiterelement 30" verformt wird. Es erfolgt eine Erhöhung der Feldstärke im Bereich der integrierten Schaltungen 26, 26' auf etwa 0,05 Tesla.

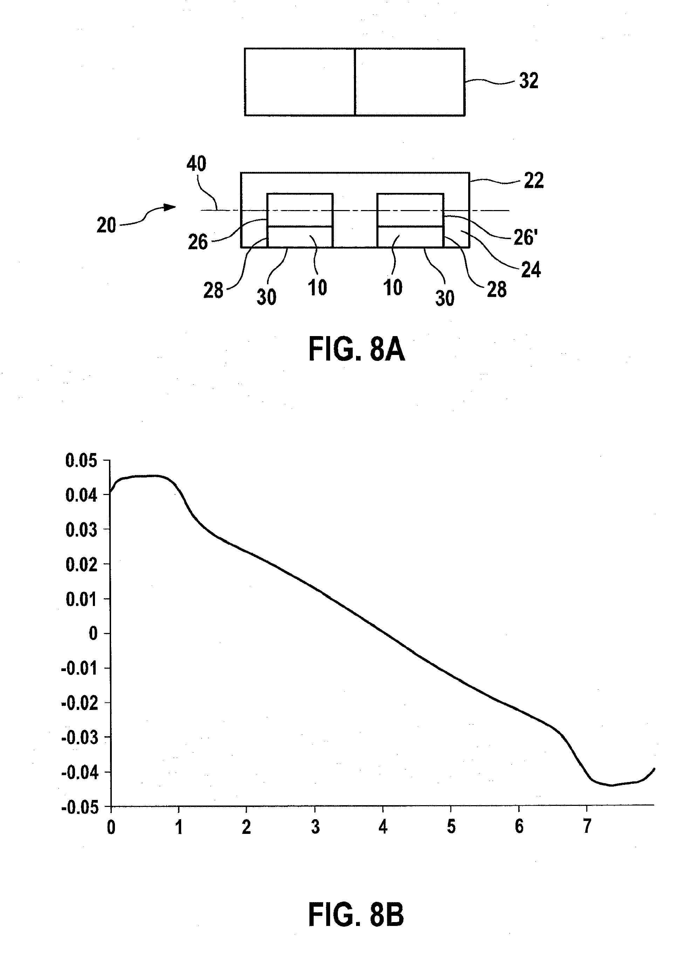

Die Fig. 8A zeigt einen Magnetfeldsensor 20 analog der Fig. 6A, der zusätzlich einen magnetischen Leiter 28 mit zwei Leiterelementen 30 analog der Fig. 2 aufweist. Jeder integrierten Schaltung 26, 26' ist ein separates Leiterelement 30 zugeordnet.

Die Fig. 8B zeigt ein Diagramm analog der Fig. 6B mit der Stärke des Magnetfelds 38 in der Ebene 40, das durch die beiden Leiterelemente 30 verformt wird. Es erfolgt eine lokale Felderhöhung im Bereich der integrierten Schaltungen 26, 26'.

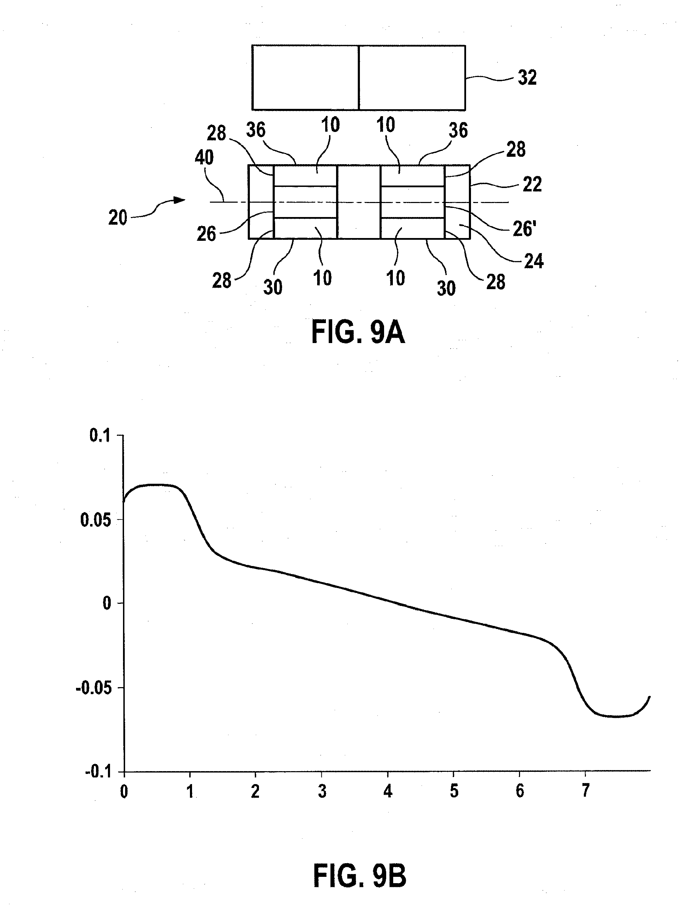

Die Fig. 9A zeigt einen Magnetfeldsensor 20 analog der Fig. 6A, der zusätzlich einen magnetischen Leiter 28 mit Leiterelementen 30 und Magnetfeldleitern 36 analog der Fig. 3 aufweist. Jeder integrierten Schaltung 26, 26' ist ein separates Leiterelement 30, 36 zugeordnet.

Die Fig. 9B zeigt ein Diagramm analog der Fig. 6B mit der Stärke des Magnetfelds 38 in der Ebene 40, das durch die beiden Leiterelemente 30 und die beiden Magnetfeldleiter 36 verformt wird. Es erfolgt eine lokale Feldüberhöhung im Bereich der integrierten Schaltungen 26, 26' und eine generelle Feldstärkeerhöhung. Die lokale Feldüberhöhung weist einen Wert von etwa 0,07 Tesla auf.

Ergänzend ist darauf hinzuweisen, dass "umfassend" keine anderen Elemente oder Schritte ausschließt und "eine" oder "ein" keine Vielzahl ausschließt. Ferner sei darauf hingewiesen, dass Merkmale oder Schritte, die mit Verweis auf eines der obigen Ausführungsbeispiele beschrieben worden sind, auch in Kombination mit anderen Merkmalen oder Schritten anderer oben beschriebener Ausführungsbeispiele verwendet werden können. Bezugszeichen in den Ansprüchen sind nicht als Einschränkung anzusehen.

## Patentansprüche

1. Magnetfeldsensor (20), umfassend:
eine integrierte Schaltung (26) mit einem Magnetfeldsensorelement;
einen magnetischen Leiter (28);
ein Gehäuse (22), in dem die integrierte Schaltung (26) und der magnetische Leiter (28) aufgenommen sind;
wobei der magnetische Leiter (28) dazu ausgeführt ist, ein Magnetfeld auf die integrierte Schaltung (26) zu lenken;
**dadurch gekennzeichnet, dass**
der magnetische Leiter (28) weichmagnetische Partikel (16) in einem Polymermaterial (12) aufweist.

2. Magnetfeldsensor (20) nach Anspruch 1,
wobei die weichmagnetischen Partikel (16) in das Polymermaterial (12) eingegossen, eingespritzt oder eingebracht worden sind.

3. Magnetfeldsensor (20) nach Anspruch 1 oder 2,
wobei das Gehäuse (22) aus dem gleichen Polymermaterial (12) wie der magnetische Leiter (28) hergestellt ist.

4. Magnetfeldsensor (20) nach einem der vorhergehenden Ansprüche,
wobei der magnetische Leiter (28) ein Leiterelement (30, 30', 30", 36) aus mit weichmagnetischen Partikeln gefülltem Polymermaterial umfasst, das an eine Seite der integrierten Schaltung (26) grenzt.

5. Magnetfeldsensor (20) nach einem der vorhergehenden Ansprüche,
wobei der magnetische Leiter (28) Leiterelemente (30, 36) aus mit weichmagnetischen Partikeln gefülltem Polymermaterial umfasst, die an gegenüberliegende Seiten der integrierten Schaltung (26) grenzen.

6. Magnetfeldsensor (20) nach einem der Ansprüche 4 oder 5,
wobei wenigstens ein Leiterelement (30') als Magnetfeldlinse ausgeführt ist.

7. Magnetfeldsensor (20) nach einem der vorhergehenden Ansprüche,
wobei der magnetische Leiter (28) ein Leiterelement (36, 36') aus mit weichmagnetischen Partikeln gefülltem Polymermaterial umfasst, das an eine Außenfläche des Gehäuses (22) grenzt.

8. Magnetfeldsensor (20) nach einem der vorhergehenden Ansprüche,
wobei der magnetische Leiter (28) ein strukturiertes Leiterelement (36') aus mit weichmagnetischen Partikeln gefülltem Polymermaterial umfasst, das an eine Seite der integrierten Schaltung grenzt (26) und das dazu ausgeführt ist, ein Magnetfeld in seiner Richtung umzulenken.

9. Magnetfeldsensor (20) nach Anspruch 8,
wobei das strukturierte Leiterelement (36') einen abgeknickten länglichen Körper umfasst.

10. Magnetfeldsensor (20) nach einem der vorhergehenden Ansprüche,
wobei der Magnetfeldsensor zwei separate integrierte Schaltungen (26, 26') mit Magnetfeldsensorelement umfasst.

11. Magnetfeldsensor (20) nach Anspruch 10,
wobei der magnetische Leiter (28) ein Leiterelement (30") aus mit weichmagnetischen Partikeln gefülltem Polymermaterial umfasst, das an beide integrierte Schaltungen grenzt.

12. Magnetfeldsensor (20) nach Anspruch 10 oder 11,
wobei der magnetische Leiter (28) für jede integrierte Schaltung (26, 26') ein Leiterelement (30) aus mit weichmagnetischen Partikeln gefülltem Polymermaterial umfasst, das an die jeweilige integrierte Schaltung grenzt.

13. Magnetfeldsensor (20) nach einem der Ansprüche 10 bis 12,
wobei der magnetische Leiter (28) für jede integrierte Schaltung (26, 26') zwei Leiterelemente (30, 36) aus mit weichmagnetischen Partikeln gefülltem Polymermaterial umfasst, die jeweils an gegenüberliegende Seiten der zugehörigen integrierten Schaltung grenzen.

14. Magnetfeldsensor (20) nach einem der vorhergehenden Ansprüche,
wobei der magnetische Leiter (28) einen Abstand zu der integrierten Schaltung (26, 26') aufweist.
